(19) **Europäisches Patentamt**
**European Patent Office**
**Office européen des brevets**

(11) **EP 2 440 623 B1**

(12) **EUROPEAN PATENT SPECIFICATION**

(45) Date of publication and mention
of the grant of the patent:
**05.10.2016 Bulletin 2016/40**

(51) Int Cl.:
***C09D 5/00*** *(2006.01)*

(21) Application number: **10726391.5**

(22) Date of filing: **11.06.2010**

(86) International application number:
**PCT/US2010/038264**

(87) International publication number:
**WO 2010/144770 (16.12.2010 Gazette 2010/50)**

(54) **METHOD FOR SHIELDING A SUBSTRATE FROM ELECTROMAGNETIC INTERFERENCE**

VERFAHREN ZUR ABSCHIRMUNG EINES SUBSTRATS GEGEN ELEKTROMAGNETISCHE STÖRUNG

PROCÉDÉ DE PROTECTION D'UN SUBSTRAT CONTRE LES INTERFÉRENCES ÉLECTROMAGNÉTIQUES

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **12.06.2009 US 186415 P**
**12.06.2009 US 186492 P**

(43) Date of publication of application:
**18.04.2012 Bulletin 2012/16**

(73) Proprietor: **LORD Corporation**
**Cary, NC 27511 (US)**

(72) Inventors:
• **FORNES, Timothy, D.**
**Apex**
**NC 27502 (US)**

• **CARRUTHERS, Seth, B.**
**Raleigh**
**NC 27612 (US)**
• **HUFFMAN, Nicholas, D.**
**Raleigh**
**NC 27605 (US)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(56) References cited:
**WO-A1-2004/099317     WO-A2-2008/048840**
**WO-A2-2008/048928     US-A- 6 013 203**
**US-A1- 2006 121 271**

**Description**

FIELD OF THE INVENTION

The present invention relates to a method for shielding a substrate from electromagnetic interference shielding.

BACKGROUND OF THE INVENTION

Electromagnetic interference (EMI) is a common issue encountered in electronics communications. Foreign radiation is well known to induce undesirable currents in electronic components, thereby disrupting the normal operations. This issue is of particular concern in avionics applications as foreign frequencies may disrupt flight control and compromise passenger safety. Foreign radiations can arise from numbers sources, e.g. radio communications, electricity transmission, electronic devices, lightning, static, and even nuclear electromagnetic pulses (EMP) from weapons. In order to help protect against such effects, it is common to completely shield an electronic device or component via enclosures, coatings, gaskets, adhesives, sealants, wire sleeves, metal meshes or filters among other things. A common attribute in all of these solutions is that the shielding material be electrically conductive and coincidently have a low electrical impedance. In general, the level of shielding is proportional to the material's conductivity.

It is this reason why metals like aluminum and steel are commonly used for making EMI enclosures. One downside to such enclosures, particularly from an aerospace and transportation perspective, is the weight penalty associated with using metals. The need for lightweight shielding materials has prompted manufactures to create thermoplastic or composite boxes. Shielding is achieved In these systems via a number of ways, i.e. embedding metal foils or wires in the polymer, deposition or plating of thin metallic coatings, and metallic paints. Unfortunately, these techniques each have their downsides which include limited shielding effectiveness, large-scale manufacturability issues, corrosion issues, limited choice of polymer substrates among other limitations. Material cost can also be issues as many of these polymer composites are comprised of expensive metals, such as silver, nickel, or copper.

Additional EMI shields may use metal wire screens or meshes for weight reduction or the need for optical transparency. Metal wire screens are used due to their inherently high electrically conductivity, which is a requirement for effective EMI shielding. However, EMI screens also have their limitations such as limited shielding effectiveness at GHz frequencies, handling of the delicate screen, incorporation and grounding of the screen within the enclosure, and repair of damaged enclosures in the field.

Furthermore, many existing EMI shielding materials do not provide a clear path to ground which is desirable in applications such as aircraft skins. EMI shielding materials such as expanded metal foils (EMF) embedded into an insulating resin matrix generally do not possess orthogonal conductivity. To electrically connect panels with EMF materials, the manufacturer must sand through the resin matrix and expose both EMF's. An adjoining conductive strap must then be adhered across the panels and care must be given to not create a raised scar defect.

High end shielding applications require shielding levels in excess of 60 dB over a broad range of frequencies. Very high shielding levels, often needed in aerospace and military applications, require levels in excess of 90 dB. State of the art materials are often challenged to meet these stringent requirements while also being lightweight, inexpensive, and easy to apply and repair.

It is to these perceived needs and limitations in current materials and methods that the present invention is directed.

WO 2008/048840, WO 2008/048928 and US 2006/121271 relate to self-assembled monolayers which can be used to form very thin conductive patterns that provide EMF shielding to a substrate.

WO 2004/099317 relates to a shape-formed polymer filled with a conductive filler.

US 6,013,203 relates to an electrically conductive paint to be used for EMI shielding on a substrate, the paint contains an organic resin, conductive filler, cross linker, and catalyst.

The present invention relates to a method for shielding a substrate from electromagnetic interference, said method comprising:

(i) providing a substrate,
(ii) providing an electromagnetic interference (EMI) shielding composition to the substrate, wherein the electromagnetic interference shielding composition comprises a filled, curable material capable of self-assembling to form conductive pathways during a cure process, wherein the curable material comprises a curable organic compound and a filler, said organic compound comprising a relatively non-polar resin and a polar curing agent, and said filler being comprised of particles, said particles being coated with a non-polar coating and comprising a material that is electrically conductive, and said coated filler particles being mixed in said organic compound, and
(iii) curing the composition by means of the application of heat, wherein curing agent reacts with the resin of the curable organic compound forming a polymer having polar moieties thereon, resulting in a repulsive interaction between the non-polar coating on the filler and the polar moieties on the polymer, causing the filler to self-assemble into conductive pathways through the composition.

Preferred embodiments of the invention are apparent from the dependent claims.

SUMMARY OF THE INVENTION

In a preferred embodiment of the present invention, the materials described in U.S. Patent Application No. 12/055,789, filed March 26, 2008, and published as U.S. 2010/0001237, are employed as a conductive matrix formed in-situ during the cure and applied to a substrate to provide EMI shielding.

In an effort to address the various issues with existing EMI shielding materials, an embodiment of the present invention employs an EMI composition comprising a reactive organic compound and electrically conductive filler that during the cure of the organic compound is capable of self-assembling into a heterogeneous structure comprised of a continuous, three-dimensional network of metal situated among (continuous or semi-continuous) polymer rich domains whose electrical and, optionally thermal, conductivity is within several orders of magnitude of that of bulk metals. Current state of the art compositions often lack high conductivity combined with such properties as light weight, dispensability, and adhesion, which are often required for robust EMI shielding applications. It is only through the embodiments of the present invention, that the filler loading necessary to achieve very high levels of conductivity are obtainable while maintaining the density, rheology and adhesive properties necessary for a successful material.

In one aspect of the present invention, a method for shielding a substrate from electromagnetic interference is provided comprising providing a substrate, providing an electromagnetic interference (EMI) shielding composition to the substrate, wherein the electromagnetic interference shielding composition comprises a filled, curable material capable of self-assembling to form conductive pathways during a cure process. In another embodiment of the present invention, the curable material comprises a curable organic compound and a filler, and the filler and the organic compound exhibit an interaction during the cure of the organic compound, said interaction causing the filler to self-assemble into conductive pathways.

In an additional embodiment of the present invention, the curable composition comprises an epoxy resin, and epoxy curative, and a fatty acid coated conductive filler. In a preferred embodiment of the present invention, the epoxy resin comprises diglycidyl ether of bisphenol F, and the epoxy curative comprises a polyamine anhydride adduct based on reaction between phthalic anhydride and diethylenetriamine.

In one embodiment of the present invention, the composition is applied to the substrate in a predetermined pattern comprising a predefined line thickness and a predefined aperture size, and in a preferred embodiment the composition as applied to the substrate is optically transparent.

In one preferred embodiment of the present invention, the composition has a shielding effectiveness of at least 20 dB between 1 MHz and 40 GHz., and more preferably the composition provides a shielding effectiveness of at least 80 dB between 1 MHz and 40 GHz.

In an additional aspect of the present invention, the step of providing an EMI shielding composition to a substrate comprises, identifying a damaged section of an EMI shielding system comprising at least one discontinuous conductive pathway, depositing the EMI shielding composition onto the damaged section, and curing the deposited composition to provide at least one self-assembled conductive pathway completing the at least one discontinuous conductive pathway in the damaged section.

In a further embodiment of the present invention, the EMI protection system comprises at least one of a conductive sheet metal, metal foil, metal mesh, carbon-metal fiber co-weaves, metalized carbon, or filled conductive polymer. And in a still further embodiment of the present invention, the EMI shielding system comprises a filled, curable material capable of self-assembling to form conductive pathways during a cure process.

A still further aspect of the present invention provided a method for non-destructive testing of an EMI shielding material comprising, providing an electrically conductive composition capable of providing EMI shielding, measuring an electrical property of the composition, and equating the measured electrical property of the composition with the electrical conductivity of a previously degraded sample of the composition to determine the degree of degradation of the composite. In the present invention, the composition comprises a curable material capable of self-assembling to form conductive pathways during a cure process. An in another embodiment of the present invention, the electrical property comprises electrical resistivity.

Because of the heterogeneous structure formed, the EMI shielding composition is able to induce a percolated network of conductive particles at particle concentrations considerable below that of traditional compositions that possess homogenous structures comprised of particles uniformly situated throughout the polymer matrix. Moreover, the heterogeneous structure formed during curing permits the sintering of particles thereby eliminating contact resistance between particles and In turn leading to dramatic improvements in thermal and electrical conductivity. Moreover, the continuous pathway of sintered metal permits carrying of substantial amounts of heat and electrical current which may be encountered in heat intensive or electric field intensive applications. The combination lower filler loading and related self-assembling of continuous pathways permits EMI materials that are lighter weight, easier to process, and have more resin available for improved wetting and adhesion to substrates.

Due to Its isotropic nature, the composite is conductive in all orthogonal directions; thereby lending to significantly improved electrical and thermal conductivity in the z-direction of composite structures. In turn, this improvement allows for considerable reduction resistances at interface thereby improving grounding and heat transfer which are critical to shielding and improving performance of electronic components.

Furthermore, because of its highly conductive, isotropic nature it is capable of being used a multifunctional material for the purpose of protection against electromagnetic interference and, but not limited to, eliminating buildup of static charge, a heat conduit for melting ice (e.g. deicing material), and protecting against lightning strikes. Moreover, the structure formed inherently has a geometry akin to a three dimensional mesh which acts as a natural aperture; thereby provide increased shielding for certain wavelengths.

In another embodiment of the present invention, because of the organic component's ability to react and form covalent bonds, it can be easily co-cured with or cured on reactive or non-reactive (e.g. thermoplastic or a previously reacted thermoset) substrates, respectively.

Furthermore, the uncured (A-staged or B-staged, but not C-staged) composition has desirable handling properties and is easily adaptable to various application forms. Such forms include, but are not limited to, a dispensible adhesive, a printable ink, a form-in-place gasket, a spray coating, an adhesive film, or as resin to be used in or in conjunction with a fiber reinforced composite material such as fiber prepreg or unidirectional tape. Moreover, the composition could form the EMI enclosure itself following curing.

In a further embodiment of the present invention, the self-assembling composition may be used to produce a laminated structure of two or more layers such that one or more layers is comprised of the conductive self-assembling composition.

Furthermore, in an embodiment of the present invention, the uncured composition is employed in combination with an existing EMI material to create a unique hybrid structure thereby producing attractive combinations of EMI protection and weight. Examples include, but are not restricted to, the self-assembling material used a B-staged film for embedding solid metal foils and metal screens or meshes.

In another embodiment of the present invention, the self-assembling composition is capable of electrically bridging interfaces associated with the assembly of different sections of EMI materials or during the repair of EMI materials. In additional embodiments of the present invention, the material may be applied as an uncured spray coating, uncured (not C-staged) film adhesive, or as flexible cured film that is bonded using a secondary adhesive or resin that is optionally filled with a conductive filler. In a further embodiment of the present invention, the existing or adjoining substrate to be repaired or bonded to may be of the same composition as the self-assembling heterogeneous material or be based on existing EMI systems such as those based on, but not limited to, metal foils or screens.

Furthermore, because of its highly conductive, isotropic nature, the materials discussed herein lend themselves to quantitative non-destructive testing. In a further embodiment of the present invention, the conductivity of the cured composition may be measured for the purposes of, but not limited to, assessing the defects during the manufacturing of the protected part, assessing the extent of damage of the EMI material, or degradation of the material of materials performance in the field.

In a further embodiment of the present invention, the materials, structures, and processes of the present invention further provide protection against electromagnetic pulses (EMP) from, for example, nuclear weapons.

In another embodiment of the present invention, the self-assembling materials act as both an adhesive for joining parts as well as an EMI shield. In embodiments of the present invention, the self-assembling material is employed to joint metallic parts to non-metallic parts through the adhesive properties of the material. The same material may also be coated on the non-metallic part so as to provide EMI shielding, and conductive pathways are provided through the material between the coated non-metallic part and the metallic part.

In another embodiment of the present invention, the cured self-assembled material provides a clear path to ground along the skin of a composite aircraft or other substrate. In addition to improving the lightning strike protection and EMI shielding properties, this path to ground also allows manufacturers to reduce the amount of grounding wires and labor while using the aircraft's conductive skin layer to tie into the ground plane. Through the cure process, the self-assembling material provides an electrical connection to any adjoining metal frames or other conductive films. The ease of forming this electrical connection is due to the self-assembling adhesive film's orthogonal conductivity and ability to flow during the cure process.

In a further aspect of the present invention, the highly conductive, self-assembling adhesive or composite possessing exceptionally high electrical conductivity and electromagnetic shielding effectiveness at reduced filler loadings is applied to a substrate in a particular pattern of interconnecting traces of known thickness and aperture size to create a electromagnetic interference (EMI) shield/filter.

In one embodiment of the present invention, the self-assembling adhesive is dispensed into patterns using a number of techniques, e.g. jetting, screen printing, gravure printing, flexography, soft or offset lithography, mask and spray, and stencil printing. In a further embodiment of the present invention, a mesh pattern is produced by dispensing overlapping traces of the self-assembling conductive adhesive on a substrate. The material could be applied to the outer layer as a co-cured film, as a last step on the cured composite, or a splicing agent during composite fabrication or during repair. Patterning would also be useful for providing EMI shielding on optically transparent substrates. In this case, communication frequencies would be reflected, yet the article would remain transparent to visible light Preferred exemplary uses of this embodiment would be shielding windows, displays, touch screens, monitor and LCD screens, and canopies, e.g. an aircraft canopy. Such pattering typically includes a grid pattern comprising line thicknesses of from 0.0254 mm to 0.0762 mm (1 to 3 mils) and aperture sizes of 0.0508 mm to 0.381 mm (2 to 15 mils) or more, depending on the desired frequency effectiveness.

In a further embodiment, the composition could be used in the form of a conformal coating to shield electronic components at the board- and/or component-level shielding. Moreover, the electrically conductive composition would be applied as a second layer on top of an electrically insulation conformal first layer. The first layer must be comprised of an electrically insulating layer which could be of the composition or a state of art material. The high thermal conductivity of the composition combined with excellent EMI shielding would be particularly useful as a two layer system as current coating lack significant conductivity needed to adequately dissipate heat generated by electronic components.

In summary, the embodiments of the present invention employ materials which self-assemble due to a reaction-induced phase separation that occurs between the resulting polymer formed (such as, generated by reacting bisphenol F and a polyamine anhydride adduct curative) and a coated filler to create materials possessing high electromagnetic shielding capabilities. The level of shielding was shown to be ~2-10 times higher relative to composites possessing a homogeneous distribution of silver throughout the sample. In addition, the levels achieved in the cured, self-assembled composition were obtained at low filler loadings.

Thus, there has been outlined, rather broadly, the more important features of the invention in order that the detailed description that follows may be better understood and in order that the present contribution to the art may be better appreciated. There are, obviously, additional features of the invention that will be described hereinafter and which will form the subject matter of the claims appended hereto. In this respect, before explaining several embodiments of the invention in detail, it is to be understood that the invention is not limited in its application to the details and construction and to the arrangement of the components set forth in the following description or illustrated in the drawings. The invention is capable of other embodiments and of being practiced and carried out in various ways.

It is also to be understood that the phraseology and terminology herein are for the purposes of description and should not be regarded as limiting in any respect. Those skilled in the art will appreciate the concepts upon which this disclosure is based and that it may readily be utilized as the basis for designating other structures, methods and systems for carrying out the several purposes of this development.

BRIEF DESCRIPTION OF THE DRAWINGS

FIGURE 1 is a graph of shielding effectiveness of various materials, some in accordance with embodiments of the present invention.
FIGURE 2 is a scatter plot of the sheet resistance versus the shielding effectiveness of a coating in an embodiment of the present invention.

DETAILED DESCRIPTION OF THE PREFERRED EMBODIMENTS

The conductive filler self-assembles into conductive pathways during cure of the polymer matrix to provide a conductive EMI shielding material which addresses many of the disadvantages of the materials of the prior art.

The mechanism of self-assembly and structure formation is achieved through the proper selection of component materials and adherence to particular processing conditions. In one embodiment of the present invention, the filler component comprises a conductive filler (electrical and, optionally, thermal) and the organic compound comprises a monomer and optionally a curative agent. The formation of filler rich domains during reaction of the organic material allows for direct filler-to-filler particle contacts to be made. In the presence of heat the particles may further sinter together. Sintering eliminates the contact resistance between the previously non-sintered filler particles thereby substantially improving the thermal and/or electrically conductivity of the composite.

While not fully understood and not wishing to be bound by this theory, it is believed that the self-assembly and domain formation and sintering are sensitive to the organic material's cure temperature, the cure time, and the level of pressure applied during the cure. In other words, domain formation and sintering are kinetically driven processes. In a still a further embodiment, the rate at which the sample is heated will affect the extent of domain formation and sintering.

In total, the processing conditions can be tailored to achieve a conductive adhesive having the best combination of properties at minimal filler loading, which often translates to lower cost and opportunity to take advantage other properties that are adversely affected by high filler loadings. In some cases, when the adhesive is employed in an application that is not able to withstand high sintering temperatures, higher pressures or non-traditional sintering techniques may used to achieve exceptionally high conductivities.

The filler component and reactive organic compounds are chosen so as to create a homogeneous mixture when mixed. However, during the cure, it is believed that the resulting polymer formed from the organic compound then has a repulsive interaction with the filler so as to allow the composition to self-assemble into a heterogeneous compound having filler-rich domains wherein the filler composition is significantly higher than the bulk filler concentration. Thus, while the overall (bulk) filler concentration of the compound does not change, the filler particles and the organic component self-assemble *in situ* into respective regions of high concentration. This phenomenon can lead to a self-assembled network of interconnected filler particles formed *in situ* from a mixture having very few, if any, initial filler-filler contacts.

There are several approaches which may be employed to create the repulsive interaction between the filler component and the organic compound. However, in the present invention, this is achieved by coating a filler particle with a non-polar coating and mixing the coated filler in a reactive organic compound comprising a relatively non-polar resin and a polar curing agent. In an uncured state, the resin, curative, and filler form a relatively homogeneous mixture in which the coated filler and the resin are compatible with one another and form a relatively homogeneous mixture. However, with the application of heat the curing agent reacts with the resin forming a polymer having polar moieties thereon, resulting in a repulsive interaction between the non-polar coating on the filler and the polar moieties on the polymer. This repulsive interaction leads to the self-assembling of polymer-rich and filler-rich domains whose respective concentrations are significantly higher than the bulk concentrations of polymer and filler, respectively. Moreover, extensive domain formation is capable of creating continuous filler-rich domains with substantial particle to particle contact between most of the filler particles.

Other types of interactions capable of creating repulsive effects upon curing of the organic compound in the presence of the filler, could consist of, but are not limited to, electrostatic interactions, hydrogen bonding interactions, dipole-dipole interactions, induced dipole interaction, hydrophobic-hydrophilic interactions, van der Waals interactions, and metallic interactions (as with an organometalic compound and metallic filler). Other forms of repulsive interactions could arise from entropic related effects such as molecular weight differences in the polymers formed from the organic compound(s). Additionally, repulsive interactions could arise as a result of an external stimulus such as electrical field.

The domains formed upon curing of the organic compound in the presence of the filler results in filler-rich domains having a higher than bulk (average) filler concentrations and in organic rich domains having lower than bulk (average) filler concentrations. The areas of higher than average filler concentration can form semi-continuous or continuous pathways of conductive filler material extending throughout the body of the cured composition. These pathways provide a low resistance route through which electrons and/or thermal phonons can travel. In other words, the pathways or channels allow for greatly enhanced thermal or electrical conductivity. This conductive pathway may be further enhanced by sintering the filler particles together. Such highly conductive pathways are particularly beneficial for EMI shielding to better absorb the electromagnetic radiation across a wide spectrum of frequencies.

Sintering, as it is understood in the art, is a surface melting phenomenon in which particles are fused together at temperatures below the material's bulk melting temperature. This behavior is brought about by a tendency of the material to relax into a lower energy state. As such, selection of filler type, size, and shape can greatly affect the sinterability of the filler particles. Certain particles, such as thin, wide, flat, plates are often formed by shearing large particles via various milling processes. This process imparts a large amount of internal stress in addition to creating a large amount of surface area. When a certain amount of heat is added to the particles, they will have the tendency melt and fuse together thereby relieving the internal strain and decreasing the overall surface energy of the particles. For this reason, the preferred filler particles for use in the present invention are those that comprise some degree of thermal or electrical conductivity and sinter easily. In a still further embodiment of the present invention, the preferred filler comprises a metallic particle that has been subjected to cold working which has imparted strain into the structure of the filler which further enables sintering.

The sintering temperature will vary according to the material chosen as the filler, as well as the geometry of the filler particle. However, in a preferred embodiment of the present invention, it is advantageous to balance the cure of the organic compound and the sintering of the filler such that they occur simultaneously. In this embodiment, the cure temperature and profile is selected to coincide with the sintering temperature of the filler, so as the organic compound becomes repulsive to the filler and the filler particles are forced together, the individual filler particles can sinter once particle to particle contact is made. This is believed to be responsible for the continuous filler structure seen throughout the fully cured composition. In a preferred embodiment of the present invention, the sintering temperature is at least 100 °C, more preferably 150 °C, and even more preferably above 150 °C for a silver flake filler.

In another embodiment of the present invention, a low-temperature cure may be desirable. For example when coating/applying the curable composition to a heat sensitive substrate, the cure agent and cure mechanism may be tailored to achieve a cured, self-assembled material at temperatures below 50 °C. In embodiments of the present invention where sintering does not take place during a cure step, for example in a low-temperature cure environment, the particles may initially form self-assembled pathways that are not sintered. A sintering step may then be later added. This later-added sintering step may comprise heating of the cured, self-assembled material, either through ambient heating, or electrically induced heating. In embodiments not according to the present invention, the self assembling composition may be cured without the addition of heat. However, in the present invention, the composition is cured via application of heat to the composition. Heat curing is commonly accomplished in a cure oven such as a convection oven or an autoclave, whereby hot air or radiated heat is used to increase the temperature of the composition. In alternate embodiments not according to the present invention, other methods of cure may be employed such as induction curing in an electromagnetic field, microwave curing, infrared curing, electron beam curing, ultraviolet curing, and curing by visible light. Additionally, the cure reaction may be self accelerated through the use of an exothermic cure reaction. A non-thermal cure may be desirable, for example, when the composition is coated on a temperature sensitive substrate such as a plastic.

In one embodiment of the present invention the filler comprises inorganic fillers. Available fillers include pure metals such as aluminum, iron, cobalt, nickel, copper, zinc, palladium, silver, cadmium, indium, tin, antimony, platinum, gold, titanium, lead, and tungsten, metal oxides and ceramics such as aluminum oxide, aluminum nitride, silicon nitride, boron nitride, silicon carbide, zinc oxide. Carbon containing fillers could consist of graphite, carbon black, carbon nanotubes, and carbon fibers. Suitable fillers additionally comprise alloys and combinations of the aforementioned fillers. Additional fillers include inorganic oxide powders such as fused silica powder, alumina and titanium oxides, and nitrates of aluminum, titanium, silicon, and tungsten. The particulate materials include versions having particle dimensions in the range of a few nanometers to tens of microns.

In an embodiment of the present invention, the filler is present at 40 volume percent or less, based on the total volume of the cured composition. In a preferred embodiment of the present invention, the filler is present at 30 volume percent or less, based on the total volume of the cured composition. In a more preferred embodiment of the present invention, the filler is present at 15 volume percent or less, based on the total volume of the cured composition.

In the present invention, the filler comprises a material that is electrically conductive and, optionally, thermally conductive. Although metals and metal alloys are preferred for use in several embodiments of the present invention, the filler may comprise a conductive sinterable non-metallic material. In an alternate embodiment of the present invention the filler may comprise a hybrid particle wherein one type of filler, for example a non-conductive filler, is coated with a conductive, sinterable material, such as silver. In this manner, the overall amount of silver used may be reduced while maintaining the sinterability of the filler particles and conductivity of the sintered material.

In an embodiment of the present invention, the filler component must be able to interact with the organic compound to impart a heterogeneous structure in the finished material. In a preferred embodiment of the present invention as discussed above, this is accomplished through the interaction of a polar organic compound with a non-polar filler. For the preferred filler materials, such as metals, the filler is coated with a material comprising the desired degree of polarity. In one preferred embodiment of the present invention, the filler coating comprises a non-polar fatty acid coating, such as stearic, oleic, linoleic, and palmitic acids. In a still further embodiment of the present invention, the filler coating comprises at least one of several non-polar materials, such as an alkane, paraffin, saturated or unsaturated fatty acid, alkene, fatty esters, waxy coatings, or oligomers and copolymers. In additional embodiments of the present invention, non-polar coatings comprise ogranotitanates with hydrophobic tails or silicon based coatings such as silanes containing hydrophobic tails or functional silicones.

In a further embodiment of the present invention, the coating (or surfactant, coupling agent, surface modifier, etc.) is applied to the filler particle prior to the particles' incorporation into the curable composition. Examples of coating methods are, but not limited to, are deposition of the coating from an aqueous alcohol, deposition from an aqueous solution, bulk deposition onto raw filler (e.g. using a spray solution and cone mixer, mixing the coating and filler in a mill or Attritor), and vapor deposition. In yet a further embodiment, the coating is added to the composition as to treat the filler prior to the reaction between the organic components (namely the resin and curative).

in an alternate embodiment not in accordance with the present invention, the polarity of the filler/coating and polymer are reversed wherein the filler/coating comprises a polar moiety and the organic compound comprises a non-polar polymer. Similarly, in an embodiment not in accordance with the present invention, in which a repulsive effect other than polarity is employed to drive the self-assembly, the active properties of the filler and organic components may be interchange.

In a preferred embodiment of the present invention the organic compound comprises an epoxy resin and a cure agent. In this embodiment, the organic compound comprises from 60 to 100 volume percent of the total composition. In this embodiment, the organic compound comprises from 70 to 85 percent by weight of a diglycidal ether of a bisphenol compound, such as bisphenol F, and 15 to 30 percent by weight of cure agent, such as a polyamine anhydride adduct based on reaction between phthalic anhydride and diethylenetriamine.

In additional embodiments of the present invention, suitable organic compounds comprise monomers, reactive oligomers, or reactive polymers of the following type siloxanes, phenolics, navolac, acrylates (or acrylics), urethanes, ureas, imides, vinyl esters, polyesters, maleimide resins, cyanate esters, polyimides, polyureas, cyanoacrylates, benzoxazines, unsaturated diene polymers, and combinations thereof. The cure chemistry would be dependent on the polymer or resin utilized in the organic compound. For example, a siloxane matrix can comprise an addition reaction curable matrix, a condensation reaction curable matrix, a peroxide reaction curable matrix, or a combination thereof. Selection of the cure agent is dependent upon the selection of filler component and processing conditions as outlined herein to provide the desired self-assembly of filler particles into conductive pathways.

In another embodiment, due to its Isotropic nature, the composition is conductive In all orthogonal directions; thereby lending to significantly improved electrical and thermal conductivity in the z-direction of composite structures. In turn, this improvement allows for considerable reduction in capacitive effects and heat buildup associated with non-conductive resins layers present in composite laminates. Furthermore, the material can facilitate heat and electron transfer by bridging adjacent carbon fibers within or between the layers of the composite substrate. In yet a further embodiment of the present invention, the self-assembled material's highly conductive, isotropic nature, lend themselves to quantitative non-destructive testing as discussed in greater detail below.

The uncured (A-staged or B-staged, but not C-staged) self-assembling composition has desirable handling properties and is easily adaptable to various application forms. In one embodiment of the present invention, the self-assembling composition comprises a flowable adhesive (e.g. liquid or paste) that is capable of bonding to a reactive or non-reactive substrate during the cure of organic compound. Thus, the self-assembled composition comprises adhesive qualities which enhances certain application techniques and allows for stronger mechanical connections to substrates which in turn enhances the electrical connections between the substrate and the conductive network within the adhesive. The result is an adhesive capable of bonding two adjacent surfaces together while additionally providing EMI shielding. One such example is a form-in-place gasket or conformal coating.

In a further embodiment of the present invention, the self-assembling composition is provided as a two-part system wherein the curable organic component is present in an "A-side" and the cure agent is present in a "B-side", such that when mixed, the cure reaction is begun. The filler and any other optional components may reside in either the A-side, B-side or both.

In another embodiment the composition is the form of a B-staged film adhesive that is commonly used in composite applications. Furthermore, the film adhesive has optional carrier fabric, such as a non-woven veil to enhance handling properties. In yet another embodiment, the veil may be electrically conductive to further enhance the EMI shielding ability of the composition.

In another embodiment of the present invention, the composition can be applied as a spray to a substrate by addition of a solvent to the composition. In a preferred embodiment of the present invention, the solvent comprises a structure suitable for dissolving (in full or in part) the organic compound while capable of being evaporated under common processing conditions for composite structures. In a preferred embodiment of the present invention, wherein an epoxy resin is employed, the solvent comprises, but is not limited to, acetone, methylethylketone, toluene, xylene, benzyl alcohol, butyl acetate, cyclohexanone, dimethoxyethane, trichloroethylene, glycol ethers, and mixtures thereof. Moreover, the choice of solvent will be also dictated by the curative used. In one preferred embodiment, it is desirable to select a chemical such as acetone that acts a solvent for the epoxy resin and a non-solvent for the polyamine anhydride adduct. In one preferred embodiment of the present invention, the solvent comprises 0.25 to 1.5 parts by weight of the non-solvent components.

In another embodiment of the present invention, the composition is used in conjunction with fiber reinforcement (e.g. fibers, fiber tows, woven fibers or fabrics and the like) to produce a coated or pultruded fibers, composite prepreg, tapes, and the like. In other words, the composition acts as the traditional resin component used to form traditional prepreg and related materials. In a further embodiment, the self-assembled material discussed herein is amenable and facilitates many known manufacturing techniques including infiltration techniques, such as resin transfer molding, resin film infusion and vacuum assisted resin transfer molding.

In a further embodiment of the present invention, the self-assembling composition may be used to produce a laminate structure of two or more layers such that one layer comprises the conductive self-assembling composition and the underlying layer(s).

In a further embodiment of the present invention, the self-assembling composition may be used to form the enclosure structure itself through techniques, such as but not limited to, reaction injection molding, compression molding, and resin transfer molding.

In yet another embodiment of the present invention, the uncured composition is employed in combination with an existing EMI shielding system to create a unique hybrid structure thereby producing attractive combinations of EMI shielding protection and weight. Examples include, but are not restricted to, the self-assembling material used a B-staged film for embedding solid metal foils, metal screens or meshes, expanded metal foils (EMF), metalized fibers, metalized woven fibers, metalized non-woven (e.g. veils), or metal-carbon fiber co-weaves.

The methods and materials of the embodiments of the present invention may be used to provide EMI shielding via a variety of means (coating, adhesive, gasket, formed enclosure, gasket, connectors, etc.) to a variety of substrates, parts, machines, vehicles, and apparatus. In a preferred embodiment, the methods and materials of the present invention provide an EMI shielding coating to electronics enclosures, room enclosures, automotive structures or aerospace structures.

In alternate embodiments, the self-assembling material of the present invention may be used as or with the polymeric resin component of carbon fiber reinforced polymers (CFRP) materials. These CFRP, or composite, materials could consist in number of different forms such as woven-fibers embedded in resin, unidirectional fibers or tapes within a resin, or pultruded fibers that are impregnated with a resin. Fiber reinforcement can consist of many different types of fibers and many fiber configurations such as fibers made of glass, carbon, boron, aramid, silicon carbide, etc. and fiber configurations such as unidirectional tows or woven fabrics.

In another embodiment of the present invention, because of the organic component's ability to react and form covalent bonds, it can be easily co-cured with or cured on reactive or non-reactive (e.g. thermoplastic or a previously reacted thermoset) substrates, respectively. In addition, proper selection of resin chemistry potentially affords the replacement of one or more layers typically found on the outer part of an electronics enclosure, such as primer and topcoat layers used to paint the housing.

Furthermore, because of its highly conductive, isotropic nature it is capable of being used a multifunctional material for the purpose of shielding against EMI and eliminating the buildup of static charge through electrostatic dissipation, a heat conduit for melting ice (e.g. deicing material), and protecting against lightning strikes or other electrical current. Moreover, the multifunctional ability of the composition overcomes the issues of having to combine metallic structures, e.g. EMFs, with adhesive films prior to its integration into a composite structure. Furthermore, the structure formed inherently has a geometry akin to a three dimensional mesh which acts as a natural aperture; thereby provide increased shielding for certain wavelengths.

As previously mentioned, the fabrication of the EMI shield - fiber prepreg substrate may be accomplished via co-curing the materials together during typical composite processing techniques such as autoclaving curing, out of autoclave curing, or compression molding, Alternatively, the self-assembling adhesive could be applied cured after the underlying composite substrate has been cured. Moreover, the self-assembling adhesive could be cured to thermoplastic substrate. In a further embodiment, increased pressure levels which are commonly encountered in the composite processing and curing, may further aid in the sintering of the filler particles that occurs following the self-assembling of the composition.

In another embodiment of the present invention, the self-assembling material may be used as an EMI adhesive to bond and/or seal a joint, bolt, fastener, rivet, and the like. The material may provide both mechanical integrity and electrical continuity across joining sections to provide a continuous electrical path within or around the joint.

In another embodiment of the present invention, the self-assembling material is applied as a pattern to a substrate to provide EMI shielding. Patterning is particularly useful for providing EMI shielding to optically transparent substrates and to reduce the overall weight of the EMI shield. In this case, communication frequencies would be reflected, yet the article would remain transparent to visible light. Preferred exemplary uses of this embodiment would be shielding windows, displays, touch screens, monitor and LCD screens, and canopies, e.g. an aircraft canopy. Examples of optically transparent substrates are glass, polycarbonate, and polymethylmethacrylate.

In a further embodiment of the present invention, the self-assembling material of the present invention is employed for repairing damaged EMI shielding materials. This repair method overcomes the difficulties of repair associated with sheet metal, metal foils, metal meshes and other such prior art systems. Due to the unique self-assembling conductive structure of the materials of the present invention, the metal-to-metal interfaces do not require alignment as the self-assembling material will form interconnections *in situ* when the material is applied to a repair site. The particular means for employing the compositions of the preset invention in a repair procedure include spraying or painting the uncured material onto the section to be repaired, or pre-forming a B-staged or C-staged sheet, then applying the sheet to the damaged area. The previously cured self-assembling material could also withstand a second repair cure and adhere well to the newly formed repair coating. The ability to repair an enclosure by spraying the self-assembling material onto a damaged area and curing, as opposed to retrofitting sheet metal structures, would offer significant value.

In an additional embodiment of the present invention, the self-assembling EMI shielding material may be used to repair prior art EMI shielding systems such as conductive sheet metal, metal foil, metal mesh, carbon-metal fiber co-weaves, metalized carbon, or filled conductive polymer. The unique self-assembling material of embodiments of the present invention, allow for easy application to a damaged area and "automatic" alignment with the existing conductive pathways to form a continuous conductive path between he prior art system and the self-assembled repair material of the present invention.

In a further embodiment of the present invention, the self-assembling conductive material enables the use of automated manufacturing equipment for applying EMI shielding to composite structures. Examples include, but are not restricted to, applying the self-assembling material in spray form using automated spray equipment such that the sprayed material is applied to uncured fiber reinforced polymer skin on a male mold structure, or to the surface female mold structure which has been pretreated with a release agent, to single carbon fiber filament. Furthermore, the self-assembling material could be applied in combination with a multiple unidirectional filaments (e.g. tow or tape) using automated fiber or tape placement equipment and the like (e.g. automated tow placement and automate tape layers machines). The ability to form continuous electrically conductive pathways following the curing of adjacent filaments overcomes the aforementioned issues manufacturing and weight associated with state of art materials.

In a further embodiment of the present invention, the self-assembling conductive material allows for non-destructive inspection (NDI) of the material as applied to a surface. NDI techniques are critical in large sample fabrication such as composite aerospace structures and EMI shielded rooms. NDI methods allow significant savings in fabrication time and cost while also allowing mission-critical structures to be made to the utmost quality standards. The materials of the present Invention enable simple quantitative non-destructive inspection techniques for EMI shields over the lifetime of the shield.

In one embodiment of the present invention, the cured self-assembled material is electrically conductive in all 3 dimensions (width, length and thickness). Thus, electrical resistance measurements can be easily taken on the surface of the coating using a standard device such as a 4-point probe connected to an ohmmeter. The electrical resistance values can then be correlated with performance regarding the level of electromagnetic interference shielding. The surface resistance is dependent on the volume conductivity of the material as well as the thickness of the coating.

EXAMPLES

The self-assembling EMI shielding composition described in the Examples was comprised of diglycidyl ether of bisphenol F (DGEBF) resin, an amine adduct curative based on the reaction with diethylene triamine and pthalic anyhydride, and silver flake. Two different types of silver flakes were used, specifically; flake "A" had a surface area of about 1 $m^2$/g, a weight loss in air at 538°C of about 0.4% and a stearic acid coating. Flake "B" had a surface area of about 1.5 $m^2$/g, a weight loss in air at 538°C about 1% and a long chain fatty acid coating.

The samples were tested for shielding effectiveness by two methods. Method I was a modified version of MIL-STD-285 and was used for testing between frequencies of 2.6 to 18 GHz in plane wave. Samples to be tested consisted of a coating (0.0254 to 0.0508 mm (1-2 mils) thick) of the present invention on G11 epoxy board or a solid disk (1.016 mm (40 mils) thick) of the present invention. All samples for Method I of testing were fabricated to about 5.08 cm x 7.62 cm (2 inches x 3 inches) in size. The sample was inserted into specified waveguides capable of the EM frequencies of interest. The waveguide was connected in between the signal generator and the spectrum analyzer.

Method II was a modified version of MIL-DTL-83528 and was used for testing between frequencies of 30 MHz and 1 GHz in plane wave. A coating (0.0254 to 0.0508 mm (1-2 mils)thick) of the present invention was applied to a non-conductive G11 epoxy board substrate of dimensions 60.96 cm x 60.96 cm x 0.1588 cmm (24" x 24" x 0.0625"). The coated sample was placed into an aperture dividing two sealed shielded rooms. Signal generator equipment was placed in one room, while the spectrum analyzer equipment was placed in the second room.

For both testing methods, the magnitude of the transmitted electric field, $E_t$, was measured and compared to that of the incident electric field, $E_i$. The ratio the two values helps define the materials shielding effectiveness (SE):

$$SE(dB) = 20 \log (E_i / E_t)$$

If the sample's attenuation level was at the noise floor level, a pre-amp was inserted into the measurement to amply the transmitted signal. This amplification is especially useful for high shielding materials. Uncoated G11 epoxy board substrates were tested alongside coated substrates. The SE of the uncoated substrate was below 5 dB and was subtracted out from the final data.

EXAMPLE 1

A conventional conductive particle-filled adhesive not of the present invention was prepared and tested for comparison purposes. The material contained 12.7 wt% DGEBF, 1.5 wt% diethylenetriamine and 85.8 wt% (40% by volume) silver flake type A described prior. The components were mixed until uniform in a Hauschild DAC 150 FV mixer. The material was molded into 1.016 mm (40 mil) thick disks to mimic a form-in-place gasket or adhesive. The mold was then cured at 160 °C for 1 hour. The resulting material exhibited a typical homogeneous morphology in which the filler was uniformly situated throughout the polymer matrix. The sheet resistance (Ω/square) was too high to be measured by a Keithly 580 multimeter equipped with a Bridge Technology SRM 4 point probe head. The shielding effectiveness (SE) averaged 18 decibels at frequencies of 2.6 GHz to 18 GHz as tested by Method I described prior.

EXAMPLE 2

A self-assembling adhesive of the present invention was prepared using the following formulation: 27.8 wt% DGEBF, 10.7 wt% amine adduct curative, and 61.5 wt% (15% by volume) silver flake type A. The material was molded, cured and tested according to the procedures in Example 1. The sheet resistance measured less than 0.001 $\Omega$/square and the SE averaged 105 decibels. In comparison to Example 1, the self-assembling adhesive material in this example exhibited far superior SE at a lower concentration of conductive particles.

EXAMPLE 3

A self-assembling adhesive film of the present invention was prepared using 25.3 wt% DGEBF, 9.7 wt% amine adduct curative, and 65.0 wt% (17% by volume) silver flake type A. The components were mixed until uniform in a Hauschild DAC 150 FV mixer. Using a drawdown bar, a 0.0381 mm (1.5 mil) thick film of the material was cast directly onto a non-conductive substrate of 0.3175 cm (0.125°) thick G11 epoxy board. The coated substrate was then cured at 160 °C for 1 hour. The sheet resistance of the cured film was 0.05 $\Omega$/square. The SE averaged 72 decibels at frequencies of 8 GHz to 12 GHz as tested by Method I.

EXAMPLE 4

A conductive partially cured film of the present invention was prepared using the formulation described in Example 2. A 0.0762 mm (3 mil) thick film was cast using a drawdown bar onto a non-conductive substrate of Wrightion 5200 release film. The coated substrate was partially cured, or B-staged, at 90°C for 8 minutes. This resulted in a material exhibiting the appropriate level of tack and flexibility necessary for composite layup procedures.
The B-staged film was then applied to 3 uncured plies of carbon fiber reinforced polymer (CFRP) as received, specifically Toray T300 3k plain weave with Cycom 934 resin preimpregnated into the carbon graphite woven fabric. The combined 4 layer composite sample was then vacuum bagged at -88.05 kPa (-26 inches of Hg) to a flat tool surface coated with a release agent. The conductive B-staged film faced the tool surface, while peel ply and bleeder cloth layers were used on the CFRP surface. The 4 layer composite sample was cured while being vacuum bagged at 177 °C for 1 hour.
The SE of the cured sample averaged 114 decibels from 8 GHz to 12 GHz as tested by Method I. A separate sample of only the non-conductive substrate of 3 plies of cured CFRP averaged 83 decibels over 8 GHz to 12 GHz. The upper limit of this Method I test was estimated to be 115-120 decibels.

EXAMPLE 5

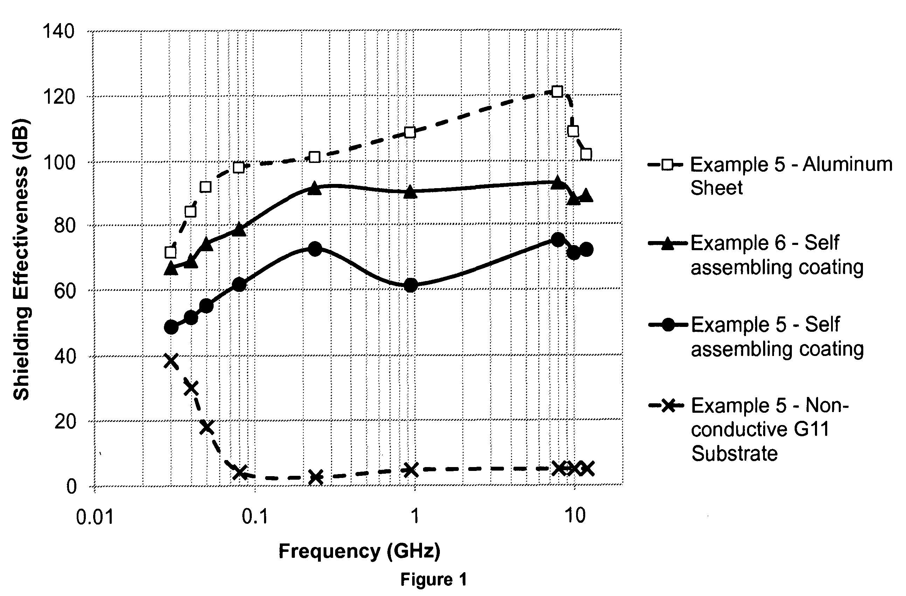

A batch of paste of the present invention was made using the formulation 36.0 wt% DGEBF, 26.8 wt% amine adduct curative, and 50.2 wt% (10% by volume) silver flake type B. A solvent blend was then mixed into the paste by the ratio of 100 parts by weight paste to 50 parts of the solvent blend. The solvent blend consisted of 50 wt% acetone, 18 wt% toluene, 16 wt% methyl ethyl ketone, 11 wt% ethyl acetate, and 5 wt% ligroine. Less than 1 wt% rheology modifiers were added to the mixture.
The resulting paint mixture was briefly mixed manually followed by 5 minutes of mixing on a standard paint shaker. The paint mixture as then loaded into a HVLP gravity feed spray gun with a 1.4 mm tip size and 206.84 kPa (30 psi) of air pressure. The paint mixture was then sprayed onto a nonconductive G11 epoxy board substrate. The coated substrate was then cured at 160 °C for 1 hour.
The resulting cured conductive coating was 0.0381 mm (1.5 mils) thick and gave a sheet resistance of 0.11 $\Omega$/square as measured by a 4 point probe. The SE was tested by Method I from 30 MHz to 1 GHz and tested by Method II from 2.6 GHz to 12 GHz.
To illustrate any aperture or substrate effects, an uncoated non-conductive G11 epoxy board was also tested for SE at the same frequencies. Additionally, to determine the maximum SE measurable by the test setup, a solid aluminum plate 0.127 cm (0.05 inches) thick was similarly tested. Figure 1 shows the SE of the spray painted conductive coating, the uncoated G11 substrate and the solid aluminum plate. Note that as expected, non-ideal aperture effects are seen at plane wave frequencies less than 240 MHz as shown by the increase in SE by the uncoated G11 epoxy board and the decrease in SE of all other samples.

EXAMPLE 6

A spray paint material of the present invention was formulated, applied and tested as set forth in Example 5, except that the solvent-free paste contained 10.3 wt% DGEBF, 3.9 wt% amine adduct curative, and 85.8 wt% (40% by volume) silver flake type B. The resulting cured coating was 0.0381 mm (1.5 mils) thick with a surface resistance of 0.015 Ω/square. The SE of the coating is shown in Figure 1.

EXAMPLE 7

A spray paint material of the present invention was formulated and applied as set forth in Example 5, except that the solvent-free paste formulation was that of Example 2. The paint mixture was spray coated onto various non-conductive substrates including G11 epoxy board, PET, polycarbonate and thermoplastic urethane. The samples were cured for 1 hour at the temperatures shown in Table 1. The cured conductive coating was 0.0381 to 0.0508 mm (1.5 - 2.0 mils) thick for all samples. The coating-substrate adhesion was measured according to ASTM D3359 with 3M™ #250 tape. The sheet resistance was measured by 4 point probe, and the SE was measured at frequencies of 8 GHz to 12 GHz by Method I. After initial testing, sample 5A was exposed to 87 hours of ASTM B-117 salt fog before re-testing as sample 5AC. All results are shown in Table 1.

TABLE 1

| | | | | | SE 8-12 GHz | |
| | | Cure | Adhesion | | | |
| Sample | Substrate | (°C) | (ASTM D3359) | Resis. (Ohm/sq) | | (dB) |
| --- | --- | --- | --- | --- | --- | --- |
| 5A | G11 | 160 | 5B | 0.04 | | 84 |
| 5AC | G11 | 160 | 5B | 0.04 | | 79 |
| 5B | PET | 120 | 4B | 0.08 | | 87 |
| 5C | PC | 120 | 4B | 0.08 | | 74 |
| 5D | TPU | 120 | 5B | 0.12 | | 80 |

EXAMPLE 8

A set of samples of the present invention was fabricated in order to determine the correlation between the sheet resistance and the SE of the cured self-assembled coating. Several spray paint coatings of the present invention were fabricated in a manner consistent with Example 5. Additional solvent-free film coatings of the present invention were fabricated in accordance to Example 3. All samples were cured onto 0.3175 cm (0.125") thick G11 epoxy board.

Several different compositions were used in fabricating the samples. The compositions consisted of varying levels of conductive filler between 40 - 86 %wt and varying types of conductive filler such as silver flake A, silver flake B, additional silver flakes and a silver-coated copper flake. The silver-coated copper flake had a surface area of about 1 $m^2$/g and weight loss in air at 538°C of about 0.7%wt. Within the set of samples, the coating thickness was between about 0.0254 to 0.2286 mm (1-9 mils) and cure temperatures between 100 - 160 °C.

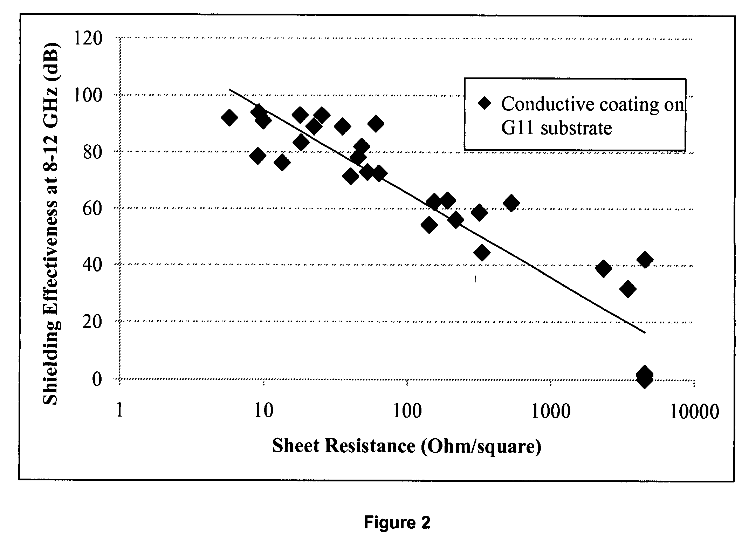

A scatter plot of the sheet resistance versus the SE of the coating is shown in Figure 2. The SE shown is the average value between 8-12 GHz as tested by Method I. This data illustrates the ability to perform a simple sheet resistance inspection measurement in order to determine the approximate range of SE within the 8-12 GHz frequencies. This procedure of a simple non-destructive test to determine final performance would be critical in the fabrication and quality control of large aerospace structures or EMI shielding shelters.

**Claims**

1. A method for shielding a substrate from electromagnetic interference, said method comprising:

(i) providing a substrate,

(ii) providing an electromagnetic interference (EMI) shielding composition to the substrate, wherein the electromagnetic interference shielding composition comprises a filled, curable material capable of self-assembling to form conductive pathways during a cure process, wherein the curable material comprises a curable organic compound and a filler, said organic compound comprising a relatively non-polar resin and a polar curing agent, and said filler being comprised of particles, said particles being coated with a non-polar coating and comprising a material that is electrically conductive, and said coated filler particles being mixed in said organic compound, and

(iii) curing the composition by means of the application of heat, wherein curing agent reacts with the resin of the curable organic compound forming a polymer having polar moieties thereon, resulting in a repulsive interaction between the non-polar coating on the filler and the polar moieties on the polymer, causing the filler to self-assemble into conductive pathways through the composition.

2. The method of claim 1, wherein the curable composition comprises an epoxy resin, and epoxy curative, and a fatty acid coated conductive filler, preferably wherein the epoxy resin comprises diglycidyl ether of bisphenol F, and more preferably wherein the epoxy curative comprises a polyamine anhydride adduct based on reaction between phthalic anhydride and diethylenetriamine.

3. The method of claim 1, wherein the non-polar coating comprises stearic acid.

4. The method of claim 1, wherein the filler particles are sinterable to form sintered conductive pathways after self-assembly during the cure.

5. The method of claim 1, wherein the composition is applied to the substrate in a predetermined pattern comprising a predefined line thickness and a predefined aperture size, preferably wherein the composition as applied to the substrate is optically transparent.

6. The method of claim 1, wherein the composition comprises less than 40 volume percent conductive filler, preferably wherein the composition comprises less than 15 volume percent conductive filler.

7. The method of claim 1, wherein said composition provides further protection from electromagnetic pulses.

8. The method of claim 1, wherein said substrate comprises at least a portion of an enclosure housing an electronic device, or wherein said enclosure comprises a vehicle, preferably wherein said enclosure comprises a microelectronic circuit.

9. The method of claim 1, wherein the self-assembled material further provides a path to ground for at least one electrical device.

10. The method of claim 1, wherein the step of providing an EMI shielding composition to a substrate comprises:

identifying a damaged section of an EMI shielding system comprising at least one discontinuous conductive pathway;
depositing the EMI shielding composition onto the damaged section; and,
curing the deposited composition to provide at least one self-assembled conductive pathway completing the at least one discontinuous conductive pathway in the damaged section.

11. The method of claim 10, wherein the EMI shielding system comprises at least one of a conductive sheet metal, metal foil, metal mesh, carbon-metal fiber co-weaves, metalized carbon, or filled conductive polymer.

12. The method of claim 10, wherein the EMI shielding system comprises a filled, curable material capable of self-assembling to form conductive pathways during a cure process.

**Patentansprüche**

1. Verfahren zum Abschirmen eines Substrats vor elektromagnetischen Störungen, wobei das Verfahren umfasst:

(i) Bereitstellen eines Substrats;
(ii) Versehen des Substrats mit einer elektromagnetische Störungen (EMI) abschirmenden Zusammensetzung, wobei die elektromagnetische Störungen abschirmende Zusammensetzung ein gefülltes härtbares Material umfasst, das während eines Härtungsvorgangs zur Selbstorganisation unter Bildung von leitfähigen Bahnen befähigt ist, wobei das härtbare Material eine härtbare organische Verbindung und einen Füllstoff umfasst, wobei die organische Verbindung ein relativ unpolares Harz und ein polares Härtungsmittel umfasst und der Füllstoff aus Teilchen besteht, wobei die Teilchen mit einer unpolaren Beschichtung beschichtet sind und ein Material umfassen, das elektrisch leitfähig ist, und die beschichteten Füllstoffteilchen in die organische Verbindung gemischt werden; und
(iii) Härten der Zusammensetzung durch Anwendung von Wärme, wobei das Härtungsmittel mit dem Harz der härtbaren organischen Verbindung reagiert, wobei ein Polymer entsteht, auf dem sich polare Struktureinheiten befinden, was zu einer abstoßenden Wechselwirkung zwischen der unpolaren Beschichtung auf dem Füllstoff und den polaren Struktureinheiten auf dem Polymer führt, was bewirkt, dass sich der Füllstoff selbst zu leitfähigen Bahnen organisiert, die durch die Zusammensetzung verlaufen.

2. Verfahren gemäß Anspruch 1, wobei die härtbare Zusammensetzung ein Epoxidharz, ein Epoxid-Härtungsmittel und einen fettsäurebeschichteten leitfähigen Füllstoff umfasst, wobei vorzugsweise das Epoxidharz Diglycidylether von Bisphenol F umfasst, wobei besonders bevorzugt das Epoxid-Härtungsmittel ein Polyaminanhydrid-Addukt umfasst, das auf der Reaktion zwischen Phthalsäureanhydrid und Diethylentriamin basiert.

3. Verfahren gemäß Anspruch 1, wobei die unpolare Beschichtung Stearinsäure umfasst.

4. Verfahren gemäß Anspruch 1, wobei die Füllstoffteilchen gesintert werden können, um nach der Selbstorganisation während der Härtung gesinterte leitfähige Bahnen zu bilden.

5. Verfahren gemäß Anspruch 1, wobei die Zusammensetzung in einem vorbestimmten Muster, das eine vordefinierte Liniendicke und eine vordefinierte Öffnungsgröße umfasst, auf das Substrat aufgetragen wird, wobei vorzugsweise die Zusammensetzung, wenn sie auf das Substrat aufgetragen ist, optisch transparent ist.

6. Verfahren gemäß Anspruch 1, wobei die Zusammensetzung weniger als 40 Vol.-% leitfähigen Füllstoff umfasst, wobei vorzugsweise die Zusammensetzung weniger als 15 Vol.-% leitfähigen Füllstoff umfasst.

7. Verfahren gemäß Anspruch 1, wobei die Zusammensetzung weiterhin Schutz vor elektromagnetischen Impulsen bietet.

8. Verfahren gemäß Anspruch 1, wobei das Substrat wenigstens einen Teil einen Gehäuses umfasst, das ein elektronisches Gerät beherbergt, oder wobei das Gehäuse ein Fahrzeug umfasst, wobei vorzugsweise das Gehäuse eine mikroelektronische Schaltung umfasst.

9. Verfahren gemäß Anspruch 1, wobei das selbstorganisierte Material weiterhin eine Erdung für wenigstens ein elektrisches Gerät liefert.

10. Verfahren gemäß Anspruch 1, wobei der Schritt des Versehens eines Substrats mit einer EMI-abschirmenden Zusammensetzung Folgendes umfasst:

Identifizieren eines beschädigten Abschnitts eines EMI-abschirmenden Systems, das wenigstens eine unterbrochene leitfähige Bahn umfasst;
Abscheiden der EMI-abschirmenden Zusammensetzung auf dem beschädigten Abschnitt; und
Härten der abgeschiedenen Zusammensetzung, wobei man wenigstens eine selbstorganisierte leitfähige Bahn erhält, die die wenigstens eine unterbrochene leitfähige Bahn in dem beschädigten Abschnitt vervollständigt.

11. Verfahren gemäß Anspruch 10, wobei das EMI-abschirmende System wenigstens eines aus einem leitfähigen Metallblech, Metallfolie, Metallgitter, Kohle-Metallfaser-Mischgewebe, metallisiertem Kohlenstoff oder einem gefüllten leitfähigen Polymer umfasst.

12. Verfahren gemäß Anspruch 10, wobei das EMI-abschirmende System ein gefülltes härtbares Material umfasst, das während eines Härtungsvorgangs zur Selbstorganisation unter Bildung von leitfähigen Bahnen befähigt ist.

**Revendications**

1. Procédé pour blinder un substrat contre les interférences électromagnétiques, ledit procédé comprenant :

(i) la fourniture d'un substrat,
(ii) la fourniture au substrat d'une composition de blindage contre les interférences électromagnétiques (EMI), selon laquelle la composition de blindage contre les interférences électromagnétiques comprend un matériau durcissable à charges capable de s'auto-assembler pour former des passages conducteurs lors d'un processus de durcissement, selon laquelle le matériau durcissable comprend un composé organique durcissable et une matière de charge, ledit composé organique comprenant une résine relativement non polaire et un agent de durcissement polaire, et ladite matière de charge comprenant des particules, lesdites particules étant enrobées d'un revêtement non polaire et comprenant un matériau qui est électriquement conducteur, et lesdites particules de matière de charge enrobées étant mélangées dans ledit composé organique, et

(iii) le durcissement de la composition au moyen de l'application de chaleur, selon lequel l'agent de durcissement réagit avec la résine du composé organique durcissable en formant un polymère sur lequel se trouvent des fractions polaires, résultant en une interaction répulsive entre le revêtement non polaire sur la matière de charge et les fractions polaires sur le polymère, provoquant l'auto-assemblage de la matière de charge en passages conducteurs à travers la composition.

**2.** Procédé selon la revendication 1, selon lequel la composition durcissable comprend une résine époxy, un durcisseur époxy, ainsi qu'une matière de charge conductrice enrobée d'acide gras, de préférence selon lequel la résine époxy comprend un éther de diglycidyle de bisphénol F, et de façon plus préférentielle selon lequel le durcisseur époxy comprend un adduit d'anhydride de polyamine basé sur la réaction entre un anhydride phtalique et une diéthylènetriamine.

**3.** Procédé selon la revendication 1, selon lequel le revêtement non polaire comprend de l'acide stéarique.

**4.** Procédé selon la revendication 1, selon lequel les particules de matière de charge peuvent être frittées pour former des passages conducteurs frittés après l'auto-assemblage lors du durcissement.

**5.** Procédé selon la revendication 1, selon lequel la composition est appliquée sur le substrat selon un motif prédéterminé comprenant une épaisseur de ligne prédéfinie et une taille d'ouverture prédéfinie, de préférence selon lequel la composition telle qu'appliquée sur le substrat est optiquement transparente.

**6.** Procédé selon la revendication 1, selon lequel la composition comprend moins de 40 % en volume de matière de charge conductrice, de préférence selon lequel la composition comprend moins de 15 % en volume de matière de charge conductrice.

**7.** Procédé selon la revendication 1, selon lequel ladite composition fournit en outre une protection contre les impulsions électromagnétiques.

**8.** Procédé selon la revendication 1, selon lequel ledit substrat comprend au moins une portion d'une enceinte logeant un appareil électronique, ou selon lequel ladite enceinte comprend un véhicule, de préférence selon lequel ladite enceinte comprend un circuit microélectronique.

**9.** Procédé selon la revendication 1, selon lequel le matériau auto-assemblé fournit en outre un passage vers la terre pour au moins un appareil électrique.

**10.** Procédé selon la revendication 1, selon lequel l'étape consistant à fournir une composition de blindage EMI sur un substrat comprend les étapes consistant à :

identifier une section endommagée d'un système de blindage EMI comprenant au moins un passage conducteur discontinu ;
déposer la composition de blindage EMI sur la section endommagée ; et
durcir la composition déposée pour fournir au moins un passage conducteur auto-assemblé terminant ledit au moins un passage conducteur discontinu de la section endommagée.

**11.** Procédé selon la revendication 10, selon lequel le système de blindage EMI comprend au moins un métal en couche conductrice, ou une feuille métallique, ou une grille métallique, ou des co-tissages de fibres de carbone-métal, ou du carbone métallisé ou un polymère conducteur à matière de charge.

**12.** Procédé selon la revendication 10, selon lequel le système de blindage EMI comprend un matériau durcissable à charges capable de s'auto-assembler pour former des passages conducteurs lors d'un processus de durcissement.

Figure 1

Figure 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2008048840 A
- WO 2008048928 A
- US 2006121271 A
- WO 2004099317 A
- US 6013203 A
- US 05578908 A
- US 20100001237 A